# EUROPÄISCHE PATENTSCHRIFT

(11) **EP 1 794 211 B1**
(45) Veröffentlichungstag und Bekanntmachung des Hinweises auf die Patenterteilung: **16.03.2011**
(21) Anmeldenummer: 05792528.1
(22) Anmeldetag: 20.09.2005
(51) Int. Cl.: C08G 73/00, C07F 1/08, H01L 51/00, H01L 51/30

(54) **VERWENDUNG VON KUPFER(I)-KOMPLEXEN IN ORGANISCHEN LICHTEMITTIERENDEN DIODEN**
USE OF A COPPER (I) COMPLEXES FOR ORGANIC LUMINESCENT DIODES
UTILISATION DE COMPLEXES DE CUIVRE(I) DANS DES DIODES ELECTROLUMINESCENTES ORGANIQUES

(30) Priorität: 24.09.2004 DE 102004046665
(43) Veröffentlichungstag der Anmeldung: 13.06.2007
(73) Patentinhaber: BASF SE, 67056 Ludwigshafen (DE)
(72) Erfinder: VOGLER, Arnd, 93051 Regensburg (DE); PAWLOWSKI, Valeri, 93053 Regensburg (DE); SCHMIDT, Hans-Werner, 95444 Bayreuth (DE); THELAKKAT, Mukundan, 95445 Bayreuth (DE); BÄTE, Markus, 95508 Kulmain (DE)
(86) Internationale Anmeldenummer: PCT/EP2005/010122
(87) Internationale Veröffentlichungsnummer: WO 2006/032449

(56) Entgegenhaltungen:
- WO-A-03/095587
- US-A1- 2002 182 441
- US-A1- 2005 079 384
- MA Y ET AL: "HIGH LUMINESCENCE GOLD(1) AND COPPER(1) COMPLEXES WITH A TRIPLET EXCITED STATE FOR USE IN LIGHT-EMITTING DIODES" ADVANCED MATERIALS, WILEY VCH, WEINHEIM, DE, Bd. 11, Nr. 10, 9. Juli 1999 (1999-07-09), Seiten 852-857, XP000865127 ISSN: 0935-9648
- Q.ZHANG, Q.ZHOU, Y.CHENG, L.WANG, D.MA, X.JING, F.WANG: "Highly efficient green phosphorescent organic light-emitting diodes based on Cu(I) complexes" ADV.MATER., Bd. 16, Nr. 5, 2004, Seiten 432-436, XP002359145 in der Anmeldung erwähnt
- L.SACCONI, S.MIDOLLINI: "Halogeno-complexes of Cobalt(I) and Nickel(I) with 1,1,1-tris(diophenylphosphinomethyl)ethane " J.CHEM.SOC.DALTON TRANS., 1972, Seiten 1213-1216, XP009058824 in der Anmeldung erwähnt
- J.P.FACKLER, J.M.FORWARD, T.GRANT,R.J.STAPLES: "Structural and spectroscopic comparisons of tris(2-(diphenylphosphino)ethyl)aminecoppe r(I)tetraphenylborate with gold(I) and silver(I) complexes" J.MOL.STRUCTURE, Bd. 470, 1998, Seiten 151-160, XP002359146 in der Anmeldung erwähnt

## Beschreibung

Die vorliegende Erfindung betrifft die Verwendung von Kupfer(I)-Komplexen der Formel I 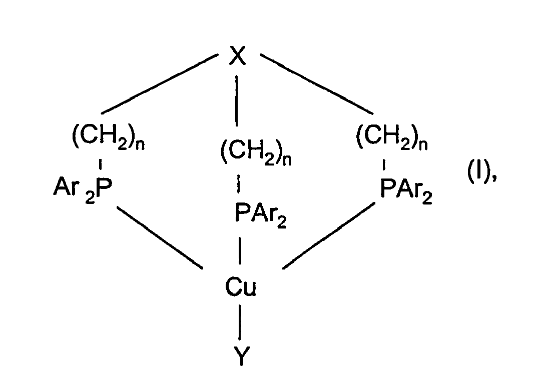 worin bedeuten
- X: Stickstoff oder ein Gruppe C-R,
- R: Alkyl oder Aryl,
- Ar: Phenyl oder Naphthyl, welches jeweils gegebenenfalls mit ein bis drei Resten ausgewählt aus der Gruppe bestehend aus Alkoxy, Alkylthio, Alkylamino, Dialky- lamino, Alkoxycarbonyl, Alkoxysulfonyl, Halogen, Cyano, Carboxyl, Hydroxysul- fonyl oder Nitro substituiert ist, wobei die beiden gegebenenfalls substituierten Phenyl- oder Naphthylreste über die zum Phosphoratom α- und α'-ständigen Kohlenstoffatome durch eine chemische Einfachbindung miteinander verknüpft sein können,
- n und: Werte von 1, 2 oder 3,
- Y: Halogen, Cyano, Thiocyanato, Alkoxy, Aryloxy, Alkylthio, Arylthio, Alkylamino, Dialkylamino, Arylamino oder Diarylamino,

in organischen lichtemittierenden Dioden (OLEDs).

Weiter betrifft die vorliegende Erfindung lichtemittierende Schichten, welche mindestens einen Kupfer(I)-Komplex der Formel I enthalten, OLEDs, welche mindestens einen Kupfer(I)-Komplex der Formel I oder eine erfindungsgemäße lichtemittierende Schicht enthalten, sowie stationäre Bildschirme, welche erfindungsgemäße OLEDs enthalten.

In OLEDs wird die Eigenschaft von Materialien ausgenutzt, Licht zu emittieren, wenn sie durch elektrischen Strom angeregt werden. OLEDs sind insbesondere interessant als Alternative zu Kathodenstrahlröhren und Flüssigkristalldisplays zur Herstellung von Flachbildschirmen. Aufgrund der sehr kompakten Bauweise und des intrinsisch niedrigeren Strornverbrauchs eignen sich Vorrichtungen, welche OLEDs enthalten, insbesondere für mobile Anwendungen, wie etwa in Handys, Laptops usw.

Es wurden zahlreiche Materialien vorgeschlagen, die bei der Anregung durch elektrischen Strom Licht emittieren (Elektrolumineszenz). Jedoch sind Kupfer-Komplexe gemäß Formel I in der Anwendung für OLEDs bisher noch nicht beschrieben worden.

Untersuchungen von Qisheng Zhang et al. (Adv. Mater. 2004, 16, No. 5, 432-436) an Kupfer(I)-Komplexen, welche zweizähnige Phenanthrolin-Derivate und entweder zwei (einzähnige) Triphenylphosphinmoleküle oder zweizähnige, über eine Etherfunktion verbrückte Triphenylphosphin-Dimere als Komplexliganden am Kupferzentrum aufweisen, zeigen die Eignung dieser Verbindungen für Anwendungen in OLEDs.

Strukturelle und spektroskopische Vergleiche von Tris(2-diphenylphosphino)ethylamin-Kupfer(I)-tetraphenylboraten zu den entsprechenden Gold(I)- und Silber(I)-Komplexen werden von John P. Fackler et al. (J. Mol. Structure 470 (1998), 151 -160) durchgeführt. Die Autoren finden z.T. starke Lumineszenz an den untersuchten Gold-, nicht jedoch an den Kupfer- und Silber- Komplexen.

L. Sacconi und S. Midollini (J. Chem. Soc. Dalton Trans. 1972, 1213 -1216) beschreiben die Synthese von Halogen-Komplexen des Cobalt(I), Nickel(I) und Kupfer(I) mit 1,1,1-Tris(diphenylphosphinomethyl)ethans.

Die beiden zuvor genannten Publikationen geben jedoch keinen Hinweis auf die mögliche Eignung der entsprechenden Kupfer-Komplexe für Anwendungen in OLEDs.

Aufgabe der vorliegenden Anmeldung war daher die Bereitstellung einer weiteren Verbindungsklasse, die zum Einsatz in verschiedenen Schichten eines OLEDs geeignet ist, insbesondere die Bereitstellung von Verbindungen, welche im blauen und grünen Bereich, im Hinblick auf die Herstellung von Vollfarbendisplays jedoch auch im roten Bereich des elektromagnetischen Spektrums Elektrolumineszenz aufweisen.

Diese Aufgabe wird gelöst durch die Verwendung der eingangs gezeigten Kupfer-Komplexe der Formel (I) in OLEDs.

Die Kupfer(I)-Komplexe der Formel I können in der lichtemittierenden Schicht eines OLEDs als Emittersubstanz oder als Matrixmaterialien für Emittersubstanzen eingesetzt werden. Desweiteren ist der Einsatz der Kupfer(I)-Komplexe als Elektronenblocker möglich, z. B. in einer Blockschicht für Elektronen, die zwischen einer lichtemittierenden Schicht und einer Löcher-transportierenden Schicht des OLEDs angeordnet ist. Bevorzugt werden die Kupfer(I)-Komplexe als Emittermoleküle in der lichtemittierenden Schicht eingesetzt.

Im Sinne der vorliegenden Anmeldung bedeuten Alkyl, Aryl und Aralkyl, Alkoxy, Alkylthio, Alkylamino, Dialkylamino, Alkyloxycarbonyl, Alkyloxysulfonylrest oder -gruppe, Alkylrest oder -gruppe, Alkoxyrest oder -gruppe und Aryloxyrest oder -gruppe die folgenden Bedeutungen:

Unter Aryl ist ein Rest mit einem Grundgerüst von 6 bis 30 Kohlenstoffatomen, bevorzugt 6 bis 18 Kohlenstoffatomen zu verstehen, der aus einem aromatischen Ring oder mehreren kondensierten aromatischen Ringen aufgebaut ist. Geeignete Grundgerüste sind zum Beispiel Phenyl, Naphthyl, Anthracenyl oder Phenanthrenyl. Dieses Grundgerüst kann unsubstituiert (d. h., dass alle Kohlenstoffatome, die substituierbar sind, Wasserstoffatome tragen) oder an einer, mehreren oder allen substituierbaren Positionen des Grundgerüsts substituiert sein.

Geeignete Substituenten sind zum Beispiel:
Alkylreste, bevorzugt Alkylreste mit 1 bis 8 Kohlenstoffatomen, besonders bevorzugt Methyl, Ethyl, i-Propyl oder t-Butyl,
Arylreste, bevorzugt C₆-Arylreste, die wiederum substituiert oder unsubstituiert sein können,
Heteroarylreste, bevorzugt Heteroarylreste, die mindestens ein Stickstoffatom enthalten, besonders bevorzugt Pyridylreste,
Alkenylreste, bevorzugt Alkenylreste, die eine Doppelbindung tragen, besonders bevorzugt Alkenylreste mit einer Doppelbindung und 1 bis 8 Kohlenstoffatomen,
   oder
Gruppen mit Donor oder Akzeptorwirkung.

Unter Gruppen mit Donorwirkung sind Gruppen zu verstehen, die einen +I- und/oder +M-Effekt aufweisen, und unter Gruppen mit Akzeptorwirkung sind Gruppen zu verstehen, die einen -I- und/oder -M-Effekt aufweisen. Geeignete Gruppen, mit Donor oder Akzeptorwirkung sind Halogenreste, bevorzugt F, Cl, Br, besonders bevorzugt F, Alkoxyreste, Carbonylreste, Esterreste, Aminreste, Amidreste, CH₂F-Gruppen, CHF₂-Gruppen, CF₃-Gruppen, CN-Gruppen, Thiogruppen oder SCN-Gruppen.

Besonders bevorzugt ist Aryl substituiert mit Resten ausgewählt aus der Gruppe bestehend aus Methyl, F, Cl und Alkoxy oder Aryl ist unsubstituiert.

Bevorzugt ist Aryl ein C₆-Arylrest, der gegebenenfalls mit mindestens einem der vorstehend genannten Substituenten substituiert ist. Besonders bevorzugt weist der C₆-Arylrest keinen, einen oder zwei der vorstehend genannten Substituenten auf, wobei der eine Substituent bevorzugt in para-Position zur weiteren Verknüpfungsstelle des Arylrestes angeordnet ist und - im Falle von zwei Substituenten - diese jeweils in meta-Position zur weiteren Verknü pfungsstelle des Arylrestes angeordnet sind.

Ganz besonders bevorzugt ist der C₆-Arylrest ein unsubstituierter Phenylrest.

Unter Alkyl ist ein Rest mit 1 bis 20 Kohlenstoffatomen, bevorzugt 1 bis 10 Kohlenstoffatomen, besonders bevorzugt 1 bis 8 Kohlenstoffatomen zu verstehen. Das Alkyl kann verzweigt oder unverzweigt sein und gegebenenfalls mit einem oder mehreren Heteroatomen, bevorzugt N, O oder S unterbrochen sein. Desweiteren kann das Alkyl mit einem oder mehreren der unter Aryl genannten Substituenten substituiert sein. Es ist ebenfalls möglich, dass das Alkyl eine oder mehrere Arylgruppen trägt. Dabei sind alle der vorstehend aufgeführten Arylgruppen geeignet. Desweiteren kann das Alkyl ein cyclisches Alkyl mit 3 bis 10 Ringatomen, bevorzugt 4 bis 7 Ringatomen sein. Bei den Ringatomen handelt es sich um Kohlenstoffatome, wobei ein oder mehrere Kohlenstoffatome durch Heteroatome, bevorzugt N, O oder S, ersetzt sein können. Das cyclische Alkyl kann mit verzweigten oder unverzweigten Alkylresten substituiert sein.

Bevorzugtes Alkyl ist ausgewählt aus der Gruppe bestehend aus Methyl, Ethyl, i-Propyl, n-Propyl, i-Butyl, n-Butyl, t-Butyl, sec-Butyl, i-Pentyl, n-Pentyl, sec-Pentyl, neo-Pentyl, n-Hexyl, i-Hexyl und sec-Hexyl, Cyclohexyl und Cyclopentyl.

Besonders bevorzugtes Alkyl ist Methyl, i-Propyl, t-Butyl und n-Hexyl.

Unter Alkoxy ist eine Gruppe der allgemeinen Formel -OR¹ zu verstehen, wobei R¹ Alkyl, wie zuvor definiert, darstellt. Bevorzugtes Alkoxy ist somit ausgewählt aus der Gruppe bestehend aus -OMethyl, -OEthyl, -OⁱPropyl, -OⁿPropyl, -OⁱButyl, -OⁿButyl, - O^{t}Butyl, -O^{sec}Butyl, - OⁱPentyl" -O"Pentyl, -O^{sec}Pentyl, -O^{neo}Pentyl, -OⁿHexyl, -OⁱHexyl und -O^{sec}Hexyl.

Besonders bevorzugtes Alkoxy ist -OMethyl, -OⁱPropyl, -O^{t}Butyl und -OⁿHexyl. Unter Aryloxy ist eine Gruppe der allgemeinen Formel -OR² zu verstehen, wobei R² Aryl, wie zuvor definiert, darstellt. Als Aryloxy ist ein Rest -OPhenyl besonders bevorzugt.

Unter Alkylthio ist eine Gruppe der allgemeinen formel -SR³ zu verstehen, wobei R³ Alkyl, wie zuvor definiert, darstellt. Bevorzugtes Alkylthio ist somit ausgewählt aus der Gruppe bestehend aus -SMethyl, -SEthyl, -SⁱPropyl, -SⁿPropyl, -SⁱButyl, SⁿButyl, - S^{t}Butyl, -S^{sec}Butyl, -SⁱPentyl, -SⁿPentyl, -S^{sec}Pentyl, -S^{neo}Pentyl, -SⁿHexyl, -SⁱHexyl und -S^{sec}Hexyl. Besonders bevorzugt ist Alkylthio -SMethyl, -SⁱPropyl, -S^{t}Butyl und -SⁿHexyl.

Unter Arylthio ist eine Gruppe der allgemeinen Formel -SR⁴ zu verstehen, wobei R⁴ Aryl, wie zuvor definiert, darstellt. Als Arylthio ist ei n Rest -SPhenyl besonders bevorzugt.

Unter Alkylamino ist eine Gruppe der allgemeinen formel -NHR⁵ zu verstehen, wobei R⁵ Alkyl, wie zuvor definiert, darstellt. Bevorzugtes Alkylamino ist somit ausgewählt aus der Gruppe bestehend aus -NHMethyl, -NHEthyl, -NHⁱPropyl, -NHⁿPropyl, -NHⁱButyl, -NHⁿButyl, -NH^{t}Butyl, -NH^{sec}Butyl, -NHⁱPentyl, -NHⁿPentyl, -NH^{sec}Pentyl, -NH^{neo}Pentyl, - NHⁿHexyl, -NHⁱHexyl und -NH^{sec}Hexyl. Besonders bevorzugt ist Alkylthio -NHMethyl, - NHⁱPropyl, -NH^{t}Butyl und -NHⁿHexyl.

Unter Arylamino ist eine Gruppe der allgemeinen Formel -NHR⁶ zu verstehen, wobei R⁶ Aryl, wie zuvor definiert, darstellt. Als Arylamino ist ein Rest -NHPhenyl besonders bevorzugt.

Unter Dialkylamino ist eine Gruppe der allgemeinen Formel -NR⁷R⁸ zu verstehen, wobei R⁷ und R⁸ unabhängig voneinander Alkyl, wie zuvor definiert, darstellt. Bevorzugtes Dialkylamino -NR⁷R⁸ enthält Reste R⁷ und R⁸, welche unabhängig voneinander ausgewählt sind aus der Gruppe bestehend aus Methyl, Ethyl, i-Propyl, n-Propyl, i-Butyl, n-Butyl, t-Butyl, sec-Butyl, i-Pentyl, n-Pentyl, sec-Pentyl, neo-Pentyl, n-Hexyl, i-Hexyl und sec-Hexyl, Cyclohexyl und Cyclopentyl. Vorzugsweise sind die Reste R⁷ und R⁸ gleich.

Unter Diarylamino ist eine Gruppe der allgemeinen Formel -NR⁹R¹⁰ zu verstehen, wobei R⁹ und R¹⁰ unabhängig voneinander Aryl, wie zuvor definiert, darstellt. Vorzugsweise sind die Reste R⁹ und R¹⁰ gleich. Als Diarylamino ist ein Rest -N(Phenyl)₂ besonders bevorzugt.

Unter Alkoxycarbonyl ist eine Gruppe der allgemeinen Formel -(CO)OR¹¹ zu verstehen, wobei R¹¹ Alkyl, wie zuvor definiert, darstellt. Bevorzugtes Alkoxycarbonyl ist somit ausgewählt aus der Gruppe bestehend aus -(CO)OMethyl, -(CO)OEthyl, -(CO)OⁱPropy), -(CO)OⁿPropyl, -(CO)OⁱButyl, -(CO)OⁿButyl, -(CO)O^{t}Butyl, -(CO)O^{sec}Butyl,- (CO)OⁱPenty), -(CO)OⁿPentyl, -(CO)O^{sec}Pentyl, -(CO)O^{neo}Pentyl, -(CO)OⁿHexyl, -(CO)OⁱHexyl und -(CO)O^{sec}Hexyl.

Besonders bevorzugtes Alkoxycarbonyl ist -(CO)O Methyl, -(CO)OⁱPropyl, -(CO)O^{t}Butyl und -(CO)OⁿHexyl.

Unter Alkoxysulfonyl ist eine Gruppe der allgemeinen Formel -(SO₂)OR¹² zu verstehen, wobei R¹² Alkyl, wie zuvor definiert, darstellt. Bevorzugtes Alkoxysulfonyl ist somit ausgewählt aus der Gruppe bestehend aus -(SO₂)OMethyl, -(SO₂)OEthyl, -(SO₂)OⁱPrOpyl, -(SO₂)OⁿPropyl, -(SO₂)OⁱButyl, -(SO₂)OⁿButyl, -(SO₂)O^{t}Butyl, -(SO₂)O^{sec}Butyl, - (SO₂)OⁱPentyl, -(SO₂)OⁿPentyl, -(SO₂)O^{sec}Pentyl, -(SO²)O^{neo}Pentyl, -(SO₂)OⁿHexyl, -(SO₂)OⁱHexyl und -(SO₂)O^{Sec}Hexyl.

Besonders bevorzugtes Alkoxysulfonyl ist -(SO₂)OMethyl, -(SO₂)OⁱPropyl, -(SO₂)O^{t}Butyl und -(SO₂)OⁿHexyl.

Bei Halogen handelt es sich bevorzugt um F, Cl oder Br, besonders bevorzugt um Cl oder Br.

Sofern die Variablen Ar zusammen zwei Phenyl- oder Naphthylreste bezeichnen, welche über die zum Phosphoratom α- und α'-ständigen Kohlenstoffatome durch eine chemische Einfachbindung miteinander verknüpft sind, ergeben sich anstelle der Einheiten -Ar₂P- in den Formeln I, la und Ib nachfolgend gezeigte Einheiten:

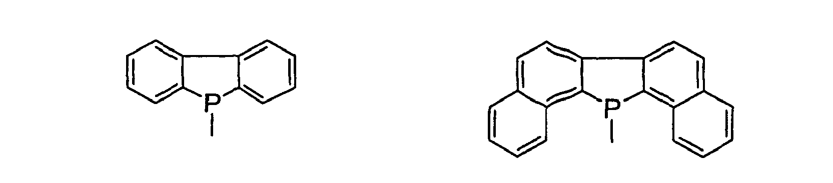

Diese Einheiten können an den Ringen gegebenenfalls noch mit den zuvor genannten Gruppen substituiert sein.

Die drei Werte 1, 2 oder 3 für n in Formel I können voneinander verschieden sein, sind jedoch vorzugsweise gleich.

Bevorzugt werden Verbindungen der Formel I erfindungsgemäß verwendet, in welchen n Werte von 1 oder 2 annimmt.

Insbesondere werden daher Verbindungen der Formel I bevorzugt verwendet, in welchen zwischen X und P entweder drei Methylen- oder drei Ethylen-Brücken vorliegen.

Gemäß einer weiteren Ausführungsform werden erfindungsgemäß bevorzugt Verbindungen der Formel I verwendet, in welchen X eine Gruppe C-R bedeutet, wobei hinsichtlich der Definition von R als Alkyl oder Aryl auf das zuvor Ausgeführte verwiesen wird.

Insbesondere kommt R in der Gruppe C-R die Bedeutung von Alkyl, wie zuvor ausgeführt, zu.

Die vorstehend genannten Kupfer(I)-Komplexe der Formel I sowie ihre bevorzugten Ausführungsformen sind hervorragend als Emittermoleküle in OLE Ds geeignet. Durch einfache Variationen der Liganden ist es möglich, Kupfer(I)-Komplexe bereit zu stellen, die Elektrolumineszenz im grünen sowie insbesondere im blauen Bereich des elektromagnetischen Spektrums zeigen. Die erfindungsgemäß verwendeten Kupfer(I)-Komplexe eignen sich, zusammen mit entsprechenden weiteren Emittern, für den Einsatz in technisch verwendbaren Vollfarbendisplays.

Die Herstellung der Kupfer(I)-Komplexe erfolgt nach dem Fachmann bekannten Verfahren. Insbesondere sei hier auf die eingangs erwähnten Literaturstellen und deren Literaturverweise Bezug genommen. Im Wesentlichen werden die Komplexe nach folgender allgemeinen Reaktionsgleichung erhalten:

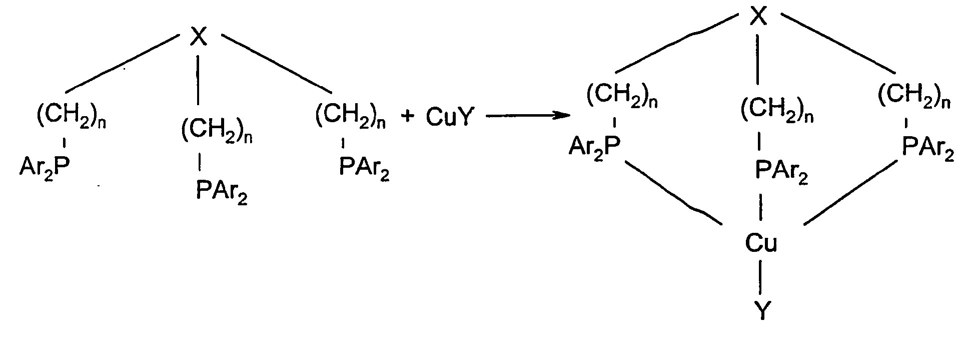

Zur Herstellung von entsprechenden dreizähnigen Liganden sei beispielsweise verwiesen auf H. Seidel, G. Huttner und G. Helmchen, Z. Naturforsch. 48 b, 1681 -1692 (1993), T. Seitz, A. Muth und G. Huttner, Chem. Ber. 127 (1994) 1837 -1842, H. Seidel, G. Huttner und L. Zsolnai, Z. Naturforsch. 50 b, 729 - 734 (1995) sowie T. Seitz, A. Muth und G. Huttner, Z. Naturforsch. 50 b, 1045 -1049 (1995).

Komplexe, in welchen Y verschieden von Halogen, Cyanato oder Thiocyanato ist, können z.B. ausgehend von den halogenhaltigen Kupfer(I)-Komplexen der Formel I durch Anionenaustausch hergestellt werden. Auch diese Austauschreaktionen sind dem Fachmann geläufig und lassen sich gemäß nachfolgender Reaktiongleichung schematisieren:

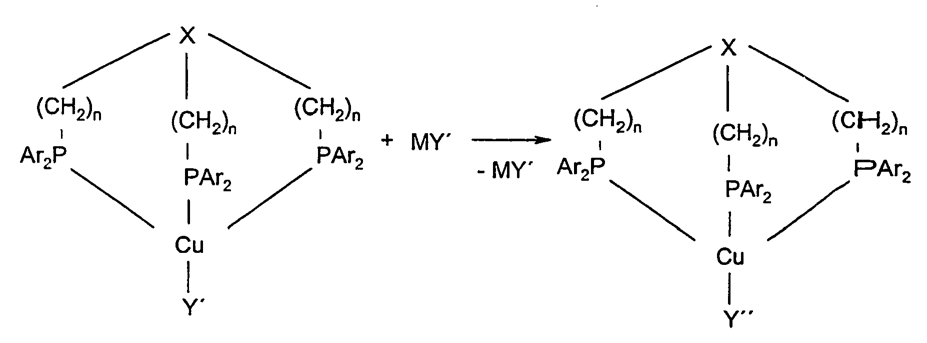

Y' steht beispielsweise für Chlor oder Brom, Y" für das dem Alkoxy-, Aryloxy-, Alkylthio-, Arylthio-, Alkylamino-, Dialkylamino-, Arylamino- oder Diarylaminorest entsprechende Anion und M für ein einwertiges Metall, wie etwa Silber(I) oder ein Alkalimetall, z.B. Natrium oder Kalium.

Die Umsetzung erfolgt bevorzugt in Lösung oder Suspension. Geeignet sind insbesondere aprotische dem Fachmann bekannte Lösungsmittel, wie etwa Toluol oder Benzoyl, Ether, z.B. Tetrahydrofuran, tert.-Butylether oder tert.-Butylmethylether, Acetonitril oder halogenierte Kohlenwasserstoffe, wie z.B. Methylenchorid.

Das molare Verhältnis von eingesetzter Kupfer(I)verbindung CuY zu eingesetztem Ligand beträgt üblicherweise 0,7 : 1,0 bis 1,5 : 1,0, vorzugsweise 0,9 : 1,0 bis 1,1 : 1,0 und insbesondere 1 : 1.

Der erhaltene Kupfer(I)-Komplex der Formel I wird nach üblichen, dem Fachmann bekannten Methoden der metallorganischen Synthese aufgearbeitet.

Die erfindungsgemäß verwendeten Kupfer(I)-Komplexe der Formel I eignen sich hervorragend als Emittersubstanzen, da sie Emission (Elektrolumineszenz) im sichtbaren Bereich des elektromagnetischen Spektrums aufweisen. Mit Hilfe der Kupfer(I)-Komplexe als Emittersubstanzen ist es möglich, insbesondere Elektrolumineszenz im blauen sowie grünen Bereich des elektromagnetischen Spektrums zu erzeugen. Desweiteren eignen sich die Kupfer(I)-Komplexe als Elektronenblocker, zum Beispiel in einer Blockschicht für Elektronen in einem OLED, die zwischen der lichtemittierenden Schicht und einer löchertransprotierenden Schicht des OLEDs angeordnet ist.

Eine besondere Eigenschaft der Kupfer(I)-Komplexe der Formel I ist, dass diese auch als Festkörper im sichtbaren Bereich des elektromagnetischen Spektrums Lumineszenz, insbesondere Elektrolumineszenz, zeigen. Daher können diese Komplexe in Substanz -ohne weitere Zusätze- als Emittersubstanzen in OLEDs eingesetzt werden. Die Herstellung eines OLEDs mit lichtemittierender Schicht ist dementsprechend o hne aufwändige Coverdampfung eines Matrixmaterials mit der Emittersubstanz möglich. Ein weiterer Gegenstand der vorliegenden Anmeldung sind daher organische Leuchtdioden (OLEDs) enthaltend mindestens einen Kupfer(I)-Komplex der Formel I.

Organische Leuchtdioden sind grundsätzlich aus mehreren Schichten aufgebaut:
1. Anode
2. löchertransportierende Schicht
3. lichtemittierende Schicht
4. elektronentransportierende Schicht
5. Kathode

Die Kupfer(I)-Komplexe können in verschiedenen Schichten des OLEDs eingesetzt werden, in Abhängigkeit von der Lage ihres HOMO, zum Beispiel können die Kupfer(I)-Komplexe als Elektronenblocker in einer Blockschicht für Elektronen oder als Emittermoleküle in der lichtemittierenden Schicht eingesetzt werden.

Bevorzugt werden sie in der lichtemittierenden Schicht als Emittermoleküle eingesetzt.

Gegenstand der vorliegenden Anmeldung ist daher auch eine lichtemittierende Schicht enthaltend mindestens einen Kupfer(I)-Komplex der Formel I. Desweiteren ist Gegenstand der vorliegenden Anmeldung eine organische lichtemittierende Diode, welche solch eine lichtemittierende Schicht enthält.

Bevorzugte Kupfer(I)-Komplexe, sind bereits vorstehend genannt worden.

Die erfindungsgemäß verwendeten Kupfer(I)-Komplexe können in Substanz - ohne weitere Zusätze - in der lichtemittierenden Schicht vorliegen. Es ist jedoch ebenfalls möglich, dass neben den erfindungsgemäß eingesetzten Kupfer(I)-Komplexen weitere Verbindungen in der lichtemittierenden Schicht vorliegen. Beispielsweise kann ein fluoreszierender Farbstoff anwesend sein, um die Emissionsfarbe des als Emittermolekül eingesetzten Kupfer(I)-Komplexes zu verändern. Desweiteren kann ein Verdünnungsmaterial eingesetzt werden. Dieses Verdünnungsmaterial kann ein Polymer sein, zum Beispiel Poly(N-vinylcarbazol) oder Polysilan. Das Verdünnungsmaterial kann jedoch ebenfalls ein kleines Molekül sein, zum Beispiel 4,4'-N,N'-Dicarbazolbiphenyl (CBP), Tetraarylsilan oder tertiäre aromatische Amine. Wenn ein Verdünnungsmaterial eingesetzt wird, beträgt der Anteil der erfindungsgemäß eingesetzten Kupfer(I)-Komplexe in der lichtemittierenden Schicht im Allgemeinen weniger als 20 Gew.-%, bevorzugt 3 bis 10 Gew.-%. Bevorzugt werden die Kupfer(I)-Komplexe in Substanz eingesetzt, wodurch eine aufwendige Coverdampfung der Kupfer(I)-Komplexe mit einem Matrixmaterial (Verdünnungsmaterial oder fluoreszierender Farbstoff) vermieden wird. Dafür ist es wesentlich, dass die Kupfer(I)-Komplexe im Festkörper lumineszieren, was für diese Komplexe auch der Fall ist. Somit enthält die lichtemittierende Schicht bevorzugt mindestens einen Kupfer(I)-Komplex der Formel I und kein weiteres Matrixmaterial, wie etwa Verdünnungsmaterial und/oder fluoreszierenden Farbstoff.

Die einzelnen der vorstehend genannten Schichten des OLEDs können aus 2 oder mehreren Schichten aufgebaut sein. Beispielsweise kann die löchertransportierende Schicht aus einer Schicht aufgebaut sein, in die aus der Elektrode Löcher injiziert werden und einer Schicht, die die Löcher von der Loch injizierenden Schicht weg in die lichtemittierende Schicht transportiert. Die elektronentransportierende Schicht kann ebenfalls aus mehreren Schichten bestehen, zum Beispiel einer Schicht, worin Elektronen durch die Elektrode injiziert werden, und einer Schicht, die aus der elektroneninjizierenden Schicht Elektronen erhält und in die lichtemittierende Schicht transportiert. Diese genannten Schichten werden jeweils nach Faktoren wie Energieniveau, Temperaturresistenz und Ladungsträgerbeweglichkeit, sowie Energiedifferenz der genannten Schichten mit den organischen Schichten oder den Metallelektroden ausgewählt. Der Fachmann ist in der Lage, den Aufbau der OLEDs so zu wählen, dass er optimal an die erfindungsgemäß als Emittersubstanzen verwendeten Kupfer(I)-Komplexe angepasst ist.

Um besonders effiziente OLEDs zu erhalten, sollte das HOMO (höchstes besetztes Molekülorbital) der löchertransportierenden Schicht an die Arbeitsfunktion der Anode angeglichen sein und das LUMO (niedrigstes unbesetztes Molekülorbital) der elektronentransportierenden Schicht an die Arbeitsfunktion der Kathode angeglichen sein.

Die Anode (1) ist eine Elektrode, die positive Ladungsträger bereitstellt. Sie kann zum Beispiel aus Materialien aufgebaut sein, die ein Metall, eine Mischung verschiedener Metalle, eine Metaillegierung, ein Metalloxid oder eine Mischung verschiedener Metalloxide enthält. Alternativ kann die Anode ein leitendes Polymer sein. Geeignete Metalle umfassen die Metalle der Gruppen Ib, IVa, Va und VIa des Periodensystems der Elemente sowie die Übergangsmetalle der Gruppe VIII. Wenn die Anode lichtdurchlässig sein soll, werden im Allgemeinen gemischte Metalloxide der Gruppen IIb, IIIb und IVb des Periodensystems der Elemente eingesetzt, zum Beispiel Indium-Zinn-Oxid (ITO). Es ist ebenfalls möglich, dass die Anode (1) ein organisches Material, zum Beispiel Polyanilin enthält, wie beispielsweise in Nature, Vol. 357, Seiten 477 bis 479 (11. Juni 1992) beschrieben ist. Zumindest entweder die Anode oder die Kathode sollten mindestens teilweise transparent sein, um das gebildete Licht auskoppeln zu können. Geeignete Lochtransportmaterialien für die Schicht (2) des erfindungsgemäßen OLEDs sind zum Beispiel in Kirk-Othmer Encyclopedia of Chemical Technologie, 4. Auflage, Vol. 18, Seiten 837 bis 860, 1996 offenbart. Sowohl löchertransportierende Moleküle als auch Polymere können als Lochtransportmaterial eingesetzt werden. Üblicherweise eingesetzte löchertransportierende Moleküle sind ausgewählt aus der Gruppe bestehend aus 4,4'-Bis[N-(1-naphthy!)-N-phenyl-amino]biphenyl (α-NPD), N,N'-Diphenyl-N, N'-bis(3-methylphenyl)-[1,1'-biphenyl]-4,4'-diamin (TPD), 1,1-Bis[(di-4-tolylamino)-phenyl]cyclohexan (TAPC), N,N'-Bis(4-methylphenyl)-N,N'-bis(4-ethylphenyl)-[1,1'-(3,3'-dimethyl)biphenyl]-4,4'-diamin (ETPD), Tetrakis-(3-methylphenyl)-N,N,N',N'-2,5-phenylendiamin (PDA), α-Phenyl-4-N,N-diphenylaminostyrol (TPS), p-(Diethylamino)-benzaldehyddiphenylhydrazon (DEH), Triphenylamin (TPA), Bis[4-(N,N-diethylamino)-2-methylphenyl)](4-methyl-phenyl)methan (MPMP), 1-Phenyl-3-[p-(diethylamino)styryl]-5-[p-(diethylamino)phenyl]pyrazolin (PPR oder DEASP), 1,2-trans-Bis(9H-carbazol-9-yl)cyclobutan (DCZB), N,N,N',N'-Tetrakis(4-methylphenyl)-(1,1'-biphenyl)-4,4'-diamin (TTB) und Porphyrinverbindungen wie Kupferphthalocyanine. Üblicherweise eingesetzte löchertransportierende Polymere sind ausgewählt aus der Gruppe bestehend aus Polyvinylcarbazolen, (Phenylmethyl)polysilanen und Polyanilinen. Es ist ebenfalls möglich, löchertransportierende Polymere durch Dotieren löchertransportierender Moleküle in Polymere wie Polystyrol und Polycarbonat zu erhalten. Geeignete löchertransportierende Moleküle sind die bereits vorstehend genannten Moleküle.

Geeignete elektronentransportierende Materialien für die Schicht (4) der erfindungsgemäßen OLEDs umfassen mit oxinoiden Verbindungen chelatisierte Metalle wie Tris(8-chinolinolato)aluminium (Alq₃), Verbindungen auf Phenanthrolinbasis wie 2,9-Dimethyl-4,7-diphenyl-1,10-phenanthrolin (BCP) oder 4,7-Diphenyl-1,10-phenanthrolin (DPA) und Azolverbindungen wie 2-(4-Biphenylyl)-5-(4-t-butylphenyl)-1,3,4-oxadiazol (PBD) und 3-(4-Biphenylyl)-4-phenyl-5-(4-t-butylphenyl)-1,2,4-triazol (TAZ). Dabei kann die Schicht (4) sowohl zur Erleichterung des Elektronentransports dienen als auch als Pufferschicht oder als Sperrschicht, um ein Quenchen des Excitons an den Grenzflächen der Schichten des OLEDs zu vermeiden. Vorzugsweise verbessert die Schicht (4) die Beweglichkeit der Elektronen und reduziert ein Quenchen des Excitons.

Die Kathode (5) ist eine Elektrode, die zur Einführung von Elektronen oder negativen Ladungsträgern dient. Die Kathode kann jedes Metall oder Nichtmetall sein, das eine geringere Arbeitsfunktion aufweist als die Anode. Geeignete Materialien für die Kathode sind ausgewählt aus der Gruppe bestehend aus Alkalimetallen der Gruppe la, zum Beispiel Li, Cs, Erdalkalimetallen der Gruppe Ila, Metallen der Gruppe IIb des Periodensystems der Elemente, und den Seltenerdmetalle und die Lanthanide und Aktinide. Des Weiteren können Metalle wie Aluminium, Indium, Calcium, Barium, Samarium und Magnesium sowie Kombinationen davon eingesetzt werden. Weiterhin können Lithium enthaltende organometallische Verbindungen oder LiF zwischen der organischen Schicht und der Kathode aufgebracht werden, um die Betriebsspannung (Operating Voltage) zu vermindern.

Das OLED gemäß der vorliegenden Erfindung kann zusätzlich weitere Schichten enthalten, die dem Fachmann bekannt sind. Beispielsweise kann zwischen der Schicht (2) und der lichtemittierenden Schicht (3) eine Schicht aufgebracht sein, die den Transport der positiven Ladung erleichtert und/oder die Bänderlücke der Schichten aneinander anpasst. Alternativ kann diese weitere Schicht als Schutzschicht dienen. In analoger Weise können zusätzliche Schichten zwischen der lichtemittierenden Schicht (3) und der Schicht (4) vorhanden sein, um den Transport der negativen Ladung zu erleichtern und/oder die Bänderlücke zwischen den Schichten aneinander anzupassen. Alternativ kann diese Schicht als Schutzschicht dienen.

In einer bevorzugten Ausführungsform enthält das erfindungsgemäße OLED zusätzlich zu den Schichten (1) bis (5) mindestens eine der im Folgenden genannten weiteren Schichten:
- eine Loch-Injektionsschicht zwischen der Anode (1) und der löchertransportierenden Schicht (2);
- eine Blockschicht für Elektronen zwischen der löchertransportierenden Schicht (2) und der lichtemittierenden Schicht (3);
- eine Blockschicht für Löcher zwischen der lichtemittierenden Schicht (3) und der elektronentransportierenden Schicht (4);
- eine Elektronen-Injektionsschicht zwischen der elektronentransportierenden Schicht (4) und der Kathode (5).

Dem Fachmann ist bekannt, wie er (zum Beispiel auf Basis von elektrochemischen Untersuchungen) geeignete Materialien auswählen muss. Geeignete Materialien für die einzelnen Schichten sind dem Fachmann bekannt und z.B. in WO 00/70655 offenbart.

Desweiteren kann jede der genannten Schichten des erfindungsgemäßen OLEDs aus zwei oder mehreren Schichten ausgebaut sein. Zudem ist es möglich, dass einige oder alle der Schichten (1), (2), (3), (4) und (5) oberflächenbehandelt sind, um die Effizienz des Ladungsträgertransports zu erhöhen. Die Auswahl der Materialien für jede der genannten Schichten ist bevorzugt dadurch bestimmt, ein OLED mit einer hohen Effizienz zu erhalten.

Die Herstellung des erfindungsgemäßen OLEDs kann nach dem Fachmann bekannten Methoden erfolgen. Im Allgemeinen wird das OLED durch aufeinanderfolgende Dampfabscheidung (Vapor deposition) der einzelnen Schichten auf ein geeignetes Substrat hergestellt. Geeignete Substrate sind zum Beispiel Glas oder Polymerfilme. Zur Dampfabscheidung können übliche Techniken eingesetzt werden wie thermische Verdampfung, Chemical Vapor Deposition und andere. In einem alternativen Verfahren können die organischen Schichten aus Lösungen oder Dispersionen in geeigneten Lösungsmitteln beschichtet werden, wobei dem Fachmann bekannte Beschichtungstechniken angewendet werden.

Im Allgemeinen haben die verschiedenen Schichten folgende Dicken: Anode (2) 500 bis 5000 Å, bevorzugt 1000 bis 2000 Å; löchertransportierende Schicht (3) 50 bis 1000 Ä, bevorzugt 200 bis 800 Å, lichtemittierende Schicht (4) 10 bis 1000 Å, bevorzugt 100 bis 800 Å, elektronentransportierende Schicht (5) 50 bis 1000 Å, bevorzugt 200 bis 800 Å, Kathode (6) 200 bis 10.000 Å, bevorzugt 300 bis 5000 Å. Die Lage der Rekombinationszone von Löchern und Elektronen in dem erfindungsgemäßen OLED und somit das Emissionsspektrum des OLED können durch die relative Dicke jeder Schicht beeinflusst werden. Das bedeutet, die Dicke der Elektronentransportschicht sollte bevorzugt so gewählt werden, dass die Elektronen/Löcher Rekombinationszone in der Lichtemittierenden Schicht liegt. Das Verhältnis der Schichtdicken der einzelnen Schichten in dem OLED ist von den eingesetzten Materialien abhängig. Die Schichtdicken von gegebenenfalls eingesetzten zusätzlichen Schichten sind dem Fachmann bekannt.

Durch Einsatz der erfindungsgemäß verwendeten Kupfer(I)-Komplexe als Emittermolekül in der lichtemittierenden Schicht der erfindungsgemäßen OLEDs können OLEDs mit hoher Effizienz erhalten werden. Die Effizienz der erfindungsgemäßen OLEDs kann desweiteren durch Optimierung der anderen Schichten verbessert werden. Beispielsweise können hoch effiziente Kathoden wie Ca, Ba oder LiF eingesetzt werden. Geformte Substrate und neue löchertransportierende Materialien, die eine Reduktion der Operationsspannung oder eine Erhöhung der Quanteneffizienz bewirken, sind ebenfalls in den erfindungsgemäßen OLEDs einsetzbar. Desweiteren können zusätzliche Schichten in den OLEDs vorhanden sein, um die Energieniveaus der verschiedenen Schichten einzustellen und Elektrolumineszenz zu erleichtern.

Die erfindungsgemäßen OLEDs können in allen Vorrichtungen eingesetzt werden, worin Elektrolumineszenz nützlich ist. Geeignete Vorrichtungen sind bevorzugt ausgewählt aus stationären und mobilen Bildschirmen. Stationäre Bildschirme sind z.B. Bildschirme von Computern, Fernsehern, Bildschirme in Druckern, Küchengeräten sowie Reklametafeln, Beleuchtungen und Hinweistafeln. Mobile Bildschirme sind z.B. Bildschirme in Handys, Laptops, Fahrzeugen sowie Zielanzeigen an Bussen und Bahnen.

Weiterhin können die erfindungsgemäß eingesetzten Kupfer(I)-Komplexe in OLEDs mit inverser Struktur eingesetzt werden. Bevorzugt werden die Kupfer(I)-Komplexe in diesen inversen OLEDs wiederum in der lichtemittierenden Schicht, besonders bevorzugt als lichtemittierende Schicht ohne weitere Zusätze, eingesetzt. Der Aufbau von inversen OLEDs und die üblicherweise darin eingesetzten Materialien sind dem Fachmann bekannt.

### Beispiel:

0,102 g (0,54 mmol) trockenes Kupfer(I)iodid wurden in 20 ml Acetonitril gelöst und mit 0,320 g (0,51 mmol) 1,1,1-Tris(diphenylphosphinomethyl)ethan in fester Form versetzt. Man ließ den Ansatz unter Rückfluss 20 Minuten kochen. Der entstandene weiße Niederschlag wurde abgesaugt, mit Acetonitril und Diethylether gewaschen und getrocknet. Der Feststoff zeigte blaue Emission bei einer Wellenlänge im Emissionsmaximum von 465 nm.

Die Elektrolumineszenz der Beispielverbindung (Emitter) wurde im Schichtaufbau

ITO/α-NPD/Cu(tripod)I/BCP/LiF/Al

ohne Matrixmaterial für den Emitter gemessen.

Hierbei bedeuten:

| | |
|---|---|
| ITO: | Indium-Zinn-Oxid |
| α-NPD: | 4,4'-Bis[N-(1-naphthyl)-N-phenyl-amino]biphenyl |
| Cu(tripod)I: | Beispielverbindung (Emitter) |
| BCP: | 2,9-Dimethyl-4,7-diphenyl-1,10-phenanthrolin |
| LiF: | Lithiumfluorid |
| Al: | Aluminium |

Das Emissionsmaximum des Emitters für diesen Schichtaufbau lag bei 526 nm.

## Patentansprüche

1. Verwendung von Kupfer(I)-Komplexen der Formel I 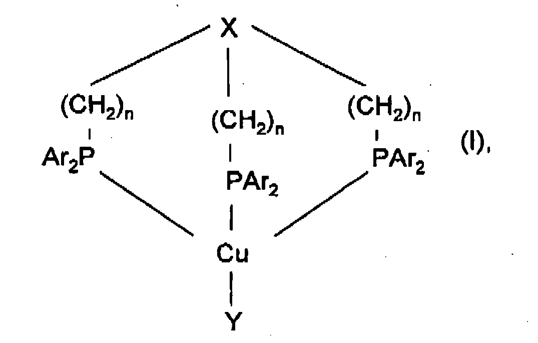 worin bedeuten
X Stickstoff oder ein Gruppe C-R,
R Alkyl oder Aryl,
Ar Phenyl oder Naphthyl, welches jeweils gegebenenfalls mit ein bis drei Res- ten ausgewählt aus der Gruppe bestehend aus Alkoxy, Alkylthio, Alkylami- no, Dialkylamino, Alkoxycarbonyl, Alkoxysulfonyl, Halogen, Cyano, Carbo- xyl, Hydroxysulfonyl oder Nitro substituiert ist, wobei die beiden gegebe- nenfalls substituierten Phenyl- oder Naphthylreste über die zum Phosphor- atom α- und α'-ständigen Kohlenstoffatome durch eine chemische Einfach- bindung miteinander verknüpft sein können,
n und Werte von 1, 2 oder 3,
Y Halogen, Cyano. Thiocyanato, Alkoxy, Aryloxy, Alkylthio, Arylthio, Alkyla- mino, Dialkylamino, Arylamino oder Diarylamino,
in organischen lichtemittierenden Dioden.

2. Verwendung nach Anspruch 1, **dadurch gekennzeichnet, dass** in Formel I n Werte von 1 oder 2 annimmt.

3. Verwendung nach Anspruch 1 oder 2, **dadurch gekennzeichnet, dass** in Formel I X eine Gruppe C-R bedeutet.

4. Verwendung nach Anspruch 3, **dadurch gekennzeichnet, dass** R in der Gruppe C-R Alkyl bedeutet.

5. Verwendung von Kupfer(I)-Komplexen der Formel I nach einem oder mehreren der Ansprüche 1 bis 4 als Emittermoleküle, Matrixmaterialien für Emitter oder Elektronenblocker in organischen lichtemittierenden Dioden.

6. Organische lichtemittierende Diode enthaltend mindestens einen Kupfer(I)-Komplex der Formel I gemäß einem oder mehreren der Ansprüche 1 bis 4.

7. Lichtemittierende Schicht enthaltend mindestens einen Kupfer(I)-Komplex der Formel I gemäß einem der Ansprüche 1 bis 4.

8. Organische lichtemittierende Diode enthaltend eine lichtemittierende Schicht gemäß Anspruch 7.

9. Stationäre Bildschirme enthaltend eine organische lichtemittierenden Diode gemäß Anspruch 6 oder 7.

## Claims

1. The use of copper(I) complexes of the formula I 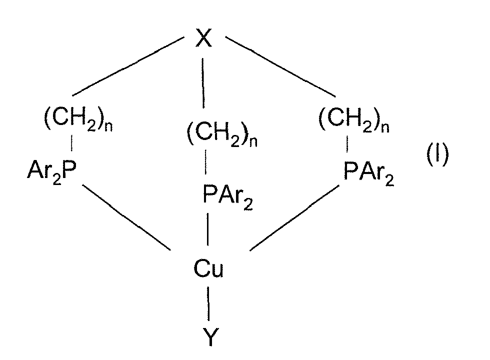 where
X is nitrogen or a C-R group,
R is alkyl or aryl,
Ar is phenyl or naphthyl, each of which is optionally substituted by from one to three radicals selected from the group consisting of alkoxy, alkylthio, alky- lamino, dialkylamino, alkoxycarbonyl, alkoxysulfonyl, halogen, cyano, car- boxyl, hydroxysulfonyl and nitro, and the two optionally substituted phenyl or naphthyl radicals may be joined to one another by a chemical single bond via the carbon atoms in the α- and α'-position relative to the phospho- rus atom,
n is 1, 2 or 3,
and
Y is halogen, cyano, thiocyanato, alkoxy, aryloxy, alkylthio, arylthio, alkylami- no, dialkylamino, arylamino or diarylamino
in organic light-emitting diodes.

2. The use according to claim 1, wherein n in formula I assumes values of 1 or 2.

3. The use according to claim 1 or 2, wherein X in formula I is a C-R group.

4. The use according to claim 3, wherein R in the C-R group is alkyl.

5. The use of copper(I) complexes of the formula I according to one or more of claims 1 to 4 as emitter molecules, matrix materials for emitters or electron blockers in organic light-emitting diodes.

6. An organic light-emitting diode comprising at least one copper(I) complex of the formula I according to one or more of claims 1 to 4.

7. A light-emitting layer comprising at least one copper(I) complex of the formula I according to any of claims 1 to 4.

8. An organic light-emitting diode comprising a light-emitting layer according to claim 7.

9. A stationary visual display unit comprising an organic light-emitting diode according to claim 6 or 7.

## Revendications

1. Utilisation de complexes de cuivre (I) de formule I 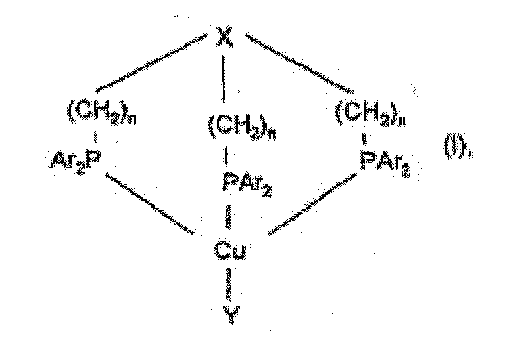 dans laquelle
X signifie l'azote ou un groupe C-R,
R signifie alkyle ou aryle,
Ar signifie phényle ou naphtyle, qui est à chaque fois éventuellement substitué avec un à trois radicaux choisis dans le groupe constitué par alcoxy, alkylthio, alkylamino, dialkylamino, alcoxycarbonyle, alcoxysulfonyle, halogène, cyano, carboxyle, hydroxysulfonyle ou nitro, les deux radicaux phényle ou naphtyle éventuellement substitués pouvant être reliés l'un à l'autre par une liaison chimique simple par le biais des atomes de carbone en position α et α' par rapport à l'atome de phosphore,
n signifie des valeurs de 1, 2 ou 3,
et
Y signifie halogène, cyano, thiocyanato, alcoxy, aryloxy, alkylthio, arylthio, alkylamino, dialkylamino, arylamino ou diarylamino,
dans des diodes organiques électroluminescentes.

2. Utilisation selon la revendication 1, **caractérisée en ce que** n prend des valeurs de 1 ou 2 dans la formule I.

3. Utilisation selon la revendication 1 ou 2, **caractérisée en ce que** X signifie un groupe C-R dans la formule I.

4. Utilisation selon la revendication 3, **caractérisée en ce que** R signifie alkyle dans le groupe C-R.

5. Utilisation de complexes de cuivre (I) de formule I selon une ou plusieurs des revendications 1 à 4 en tant que molécules émettrices, matériaux de matrice pour émetteurs ou bloqueurs d'électrons dans des diodes organiques électroluminescentes.

6. Diode organique électroluminescente contenant au moins un complexe de cuivre (I) de formule I selon une ou plusieurs des revendications 1 à 4.

7. Couche électroluminescente contenant au moins un complexe de cuivre (I) de formule I selon l'une quelconque des revendications 1 à 4.

8. Diode organique électroluminescente contenant une couche électroluminescente selon la revendication 7.

9. Écrans stationnaires contenant une diode organique électroluminescente selon la revendication 6 ou 7.
